(19) **Europäisches Patentamt**

**European Patent Office**

**Office européen des brevets**

(11) Publication number: **0 106 222**
**B1**

(12) # EUROPEAN PATENT SPECIFICATION

(45) Date of publication of patent specification: **03.08.88**

(51) Int. Cl.⁴: **G 11 C 5/00, G 11 C 11/40**

(21) Application number: **83109635.9**

(22) Date of filing: **27.09.83**

(54) Semiconductor memory device.

(30) Priority: **12.10.82 JP 178804/82**

(43) Date of publication of application:
**25.04.84 Bulletin 84/17**

(45) Publication of the grant of the patent:
**03.08.88 Bulletin 88/31**

(84) Designated Contracting States:
**DE FR GB**

(56) References cited:
**EP-A-0 089 836**
**US-A-4 260 909**
**US-A-4 288 865**

**ELECTRONICS, vol. 52, no. 11, 24th May 1979, pages 137-141, Mcgraw Hill, New York, US; G. AMIR: " V-MOS packs 16 kilobits into static random-access memory"**

**IEEE JOURNAL OF SOLID-STATE CIRCUITS, vol. SC-15, no. 4, August 1980, pages 656-660, IEEE, New York, US; M. OSAMU et al.: "2K x 8 bit Hi-CMOS static RAM's"**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Furuyama, Tohru**
**100 Fairview Square APT., 3-G**
**Ithaca, N.Y. 14850 (US)**

(74) Representative: **Henkel, Feiler, Hänzel & Partner**
**Möhlstrasse 37**
**D-8000 München 80 (DE)**

Courier Press, Leamington Spa, England.

## Description

The present invention relates to a static type semiconductor memory device.

Prior art document according to Art. 54(3) EP—A—0 089 836 discloses a static-type semiconductor memory device which includes peripheral circuits, at least a decoder, and memory cells. A high-voltage generating unit is provided so that a first power-source voltage supplied from an external unit is boosted to a second power source voltage level higher than said first power source voltage level. The first power-source voltage is supplied to the peripheral circuits and the second power-source voltage is supplied to the memory cells, thereby improving their stability in the presence of disturbances such as α-rays.

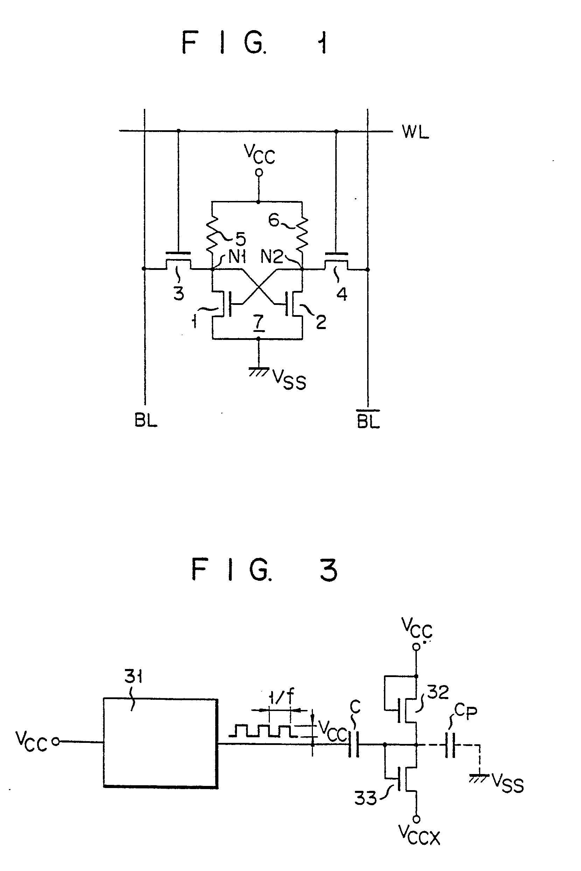

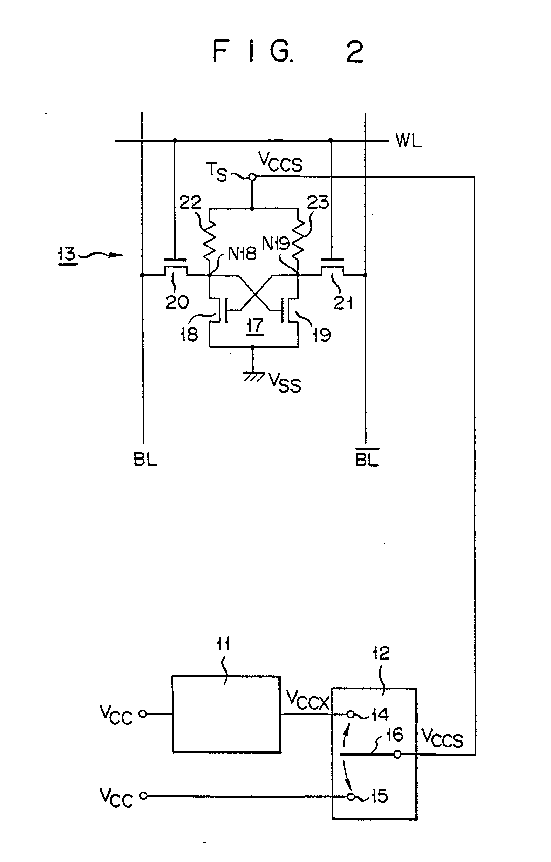

Fig. 1 shows a circuit diagram of a general semiconductor memory device. In the figure, reference numerals 1 and 2 respectively designate MOS (metal oxide semiconductor) transistors constituting a flip-flop 7; numerals 3 and 4 indicate MOS transistors serving as transfer gates; and numerals 5 and 6 are high resistance elements as loads. $V_{cc}$ denotes a power source voltage and $V_{ss}$ a reference voltage, which is ground in this instance. BL and $\overline{BL}$ denote bit lines (data input/output lines), respectively, and WL indicates a word line. The memory cell thus arranged employs a commercial power source of approximately 100 V for supplying the power source voltage $V_{cc}$ in an operation mode, i.e. a read mode or a write mode. The memory cell is supplied with a voltage which is formed by dropping the commercial power source voltage to about 5 V via a transformer. For merely holding the stored data, i.e., wait mode, the power source voltage $V_{cc}$ is switched from the commercial power source to a battery of approximately 2.5 V. This is called a battery back-up system and is widely used for data-holding in this field.

In the static type semiconductor memory device, a specific data error, called a soft error, has recently become a focus of concern. This phenomenon arises from alpha particles emitted from radioactive impurities contained in the material of the package or the memory chip, for example, U and Th. When the alpha particles enter the memory chip, electron-hole pairs are generated and a current from these pairs flows into data-storing nodes, resulting in destruction of data stored in those nodes.

The soft error problem has always been thought to be inherent only in dynamic type semiconductor memory devices, CCDs (charge coupled devices), and the like. However, recent research on soft errors shows that static type semiconductor memory devices also suffer from this undesirable phenomenon.

The soft error observed in the static type semiconductor memory device will be described referring to Fig. 1. When the alpha particles enter a memory chip, and the electron-hole pairs are generated in the memory chip, a current due to the electron-hole pairs flows through the memory cell to pull down the potential on a high potential node of the flip-flop 7 (either of the output nodes N1 or N2 of the MOS transistors 1 and 2), thereby destroying the logical state "1" or "0" of the flip-flop 7. In this way, the stored data is destroyed, i.e., a soft error occurs. The nodes N1 and N2 of the flip-flop 7 are connected to the power source voltage $V_{cc}$ through the high resistance loads 5 and 6. Therefore, when the electrons instantaneously flow into the high potential node as the result of alpha particle irradiation, the high potential node is equivalent to a floating state. The capacitance on the nodes of the static type semiconductor memory device is smaller than that of the dynamic type semiconductor memory device. Therefore, the soft error problem in the static type semiconductor memory device is more serious than in the dynamic type semiconductor memory device.

The applied voltage, when the semiconductor memory device is backed up by the battery in a wait mode, is generally about 2.5 V. The quantity of charges stored in the data storing node is reduced by half, as compared with that when the semiconductor memory device is in an operation mode with an applied voltage of approximately 5 V. Therefore, the semiconductor memory device is more sensitive to the alpha particles when it is in the battery back-up mode. This implies that the sensitivity of the static type semiconductor memory device to alpha particles is greatly determined by the sensitivity of the semiconductor memory device when it is in a battery back-up mode. Consequently, in order to solve the soft error problem, it is necessary to render the semiconductor memory device more insensitive to alpha particles when it is in a battery back-up mode.

Accordingly, an object of the present invention is to provide a static type semiconductor memory device which is substantially free from soft errors, with a considerably lessened sensitivity to alpha particles, particularly in a battery back-up mode.

According to the present invention there is provided a static type semiconductor memory device comprising: means for boosting a power source voltage, and a static memory cell for receiving the boosted output voltage from said boosting means as a power source voltage, said static type semiconductor memory device being characterized by further comprising: switch means provided between said boosting means and said memory cell and coupled with the power source voltage and the boosted output voltage, said switch means selecting the boosted output voltage in a wait mode while selecting the power source voltage in an operation mode, the selected voltage being applied as the power source voltage to said memory cell.

This invention can be more fully understood from the following detailed description when taken in conjunction with the accompanying drawings, in which:

Fig. 1 shows a circuit diagram of a conventional static type semiconductor memory cell;

Fig. 2 shows a practical arrangement of an embodiment of a semiconductor memory device according to this invention;

Fig. 3 shows an arrangement of a boosting circuit incorporated into the semiconductor memory device of Fig. 2;

Fig. 4 shows a circuit diagram of a switch circuit incorporated into the semiconductor memory device of Fig. 2;

Fig. 5 shows an arrangement of a power source circuit of the boosting circuit shown in Fig. 3; and

Fig. 6 shows an arrangement of another embodiment of a semiconductor memory device according to this invention.

Referring to Fig. 2, there is shown an embodiment of a static type semiconductor memory device according to this invention.

In the figure, reference numeral 11 designates a boosting circuit which receives the power source voltage $V_{cc}$ and boosts it to an output voltage $V_{ccx}$; numeral 12 indicates a switch circuit which receives the output voltage $V_{ccx}$ from the boosting circuit 11 and the power source voltage $V_{cc}$ and selects one of those voltages; and numeral 13 is a static type semiconductor memory device which receives the selected power source voltage $V_{ccs}$ from the switch circuit 12 as a power source voltage.

The boosting circuit 11 boosts the power source voltage $V_{cc}$ of 2.5 V, for example, to a voltage of 4 V, for example. This circuit will be described in detail later with reference to Fig. 3.

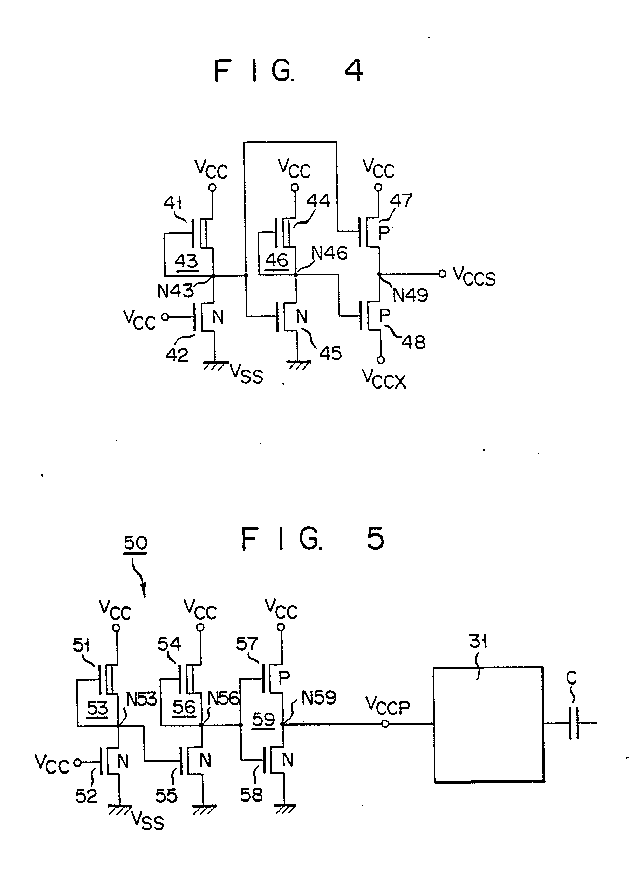

The switch circuit 12 is comprised of two input terminals 14 and 15 and a select contact 16, as schematically illustrated in Fig. 2. The details of this circuit will be given later referring to Fig. 4. The input terminal 14 receives the output voltage $V_{ccx}$ from the boosting circuit 11 and the input terminal 15 receives the power source voltage $V_{cc}$. The select contact 16, selectively coupled to the input terminals 14 and 15, selects either the output voltage $V_{ccx}$ or the power source voltage $V_{cc}$. The select contact 16, constituting a power source terminal of the switch circuit 12, is connected to a power source terminal TS. The output voltage $V_{ccx}$ or $V_{cc}$ selected by the switch circuit 12 is applied as a power source voltage $V_{ccs}$ to the semiconductor memory cell 13.

The semiconductor memory cell 13 is composed of a pair of enhancement type N-channel MOS transistors 18 and 19, enhancement type N-channel MOS transistors 20 and 21 as transfer gates, and high resistance elements 22 and 23 as loads. The gate of the MOS transistor 18 is connected to the drain of the MOS transistor 19. The gate of the MOS transistor 19 is connected to the drain of the MOS transistor 18. The sources of both the MOS transistors 18 and 19 are connected to the reference voltage $V_{ss}$, which is ground in this instance. The drain of the MOS transistor 18 is connected to the power source terminal TS via the load 22. The drain of the MOS transistor 19 is likewise connected to the power source terminal TS via the load 23. A MOS transistor 20 as a transfer gate is inserted between the drain of the MOS transistor 18 and the bit line BL. Inserted between the drain of the MOS transistor 19 and the bit line $\overline{BL}$ is a MOS transistor 21 as a transfer gate. The gates of the MOS transistors 20 and 21 are both connected to the word line WL. In the memory cell wiwm such an arrangement, the drains of the MOS transistors 18 and 19 provide data-storing nodes N18 and N19, respectively. In the write mode, the word line WL is selected, i.e., it is logical "1". Then, the gates of the MOS transistors 20 and 21 are opened, so that the data of logical "1" or logical "0" is written from the bit line BL or $\overline{BL}$ to the node N18 or N19, through the transfer gate MOS transistor 20 or 21.

The operation of the semiconductor memory device thus constructed will now be described. In the operation mode, the commercial power source is used for the power source of this semiconductor memory device. A 5 V voltage formed by dropping the commercial power source voltage is used for the power source voltage $V_{cc}$. The 5 V voltage is applied to the power source terminal of the boosting circuit 11 and the input terminal 15 of the switch circuit 12. In an operation mode, the select contact 16 of the switch circuit 12 is connected to the input terminal 15, and the power source voltage $V_{cc}$ is thereby selected. Then, the power source voltage $V_{cc}$ of approximately 5 V is directly applied as the power source voltage $V_{ccs}$ to the power source terminal TS of the semiconductor memory cell 13. In this condition, the word line WL is selected, that is, it has a logical state of "1". As a result, data of logical "1" and "0" or logical "0" and "1" are respectively written into or read out from the nodes N18 and N19 through the bit lines BL and $\overline{BL}$ and the transfer gate MOS transistors 20 and 21.

In the wait mode, the power source is switched from the commercial power source to the battery, so that the battery supplies a voltage of approximately 2.5 V as the power source voltage $V_{cc}$. Then, the select contact 16 of the switch circuit 12 is connected to the input terminal 14 to select the output voltage $V_{ccx}$ from the boosting circuit 11. The result is that the output voltage $V_{ccx}$ from the boosting circuit 11 is applied as the power source voltage $V_{ccs}$ to the power source terminal Ts of the semiconductor memory cell 13. As described above, the boosting circuit 11 is used to boost the power source voltage $V_{cc}$ from approximately 2.5 V to approximately 4 V. This will be discussed in more detail later. Thus, the boosted output voltage $V_{ccx}$ of approximately 4 V is applied to the power source terminal TS of the semiconductor memory cell 13 as the power source voltage $V_{cc}$.

The rate of soft error occurrence was measured using the conventional memory cell as shown in Fig. 1. In this measurement, alpha particles are radiated onto the memory chip while the semiconductor memory device is in a wait mode. The measured results showed that when the power source voltage $V_{cc}$ of approximately 4 V was applied, the rate of soft error occurrence was considerably reduced, as compared with the case where the power source voltage $V_{CC}$ was approximately 2.5 V. These results also showed that the sensitivity of the semiconductor memory device of this embodiment when the approximately 4 V, for example, in the wait mode, was reduced to at least one-tenth that of the conventional semiconductor memory device.

Fig. 3 shows an example of the practical arrangement of the boosting circuit 11 in the semiconductor memory device of Fig. 2.

Reference numeral 31 denotes a ring oscillator containing an odd number of inverters cascade-connected in a ring fashion (not shown). The power source voltage $V_{CC}$ is applied to the ring oscillator 31. The ring oscillator 31 produces an output signal of the voltage $V_{CC}$ and frequency f. The output terminal of the ring oscillator 31 is connected to one electrode of a capacitor C. The capacitor C receives at this electrode the output voltage of the frequency f. The other electrode of the capacitor C is connected to the source of an enhancement type N-channel MOS transistor 32 whose drain is connected to the power source voltage $V_{CC}$. The drain and gate of the MOS transistor 32 are interconnected. The drain of an N-channel MOS transistor of enhancement type is connected to the source of the MOS transistor 32. The source of the MOS transistor 33 serves as an output terminal from which the boosted output voltage $V_{CCX}$ is taken out. The gate of the MOS transistor 33 is connected to the drain thereof. A stray capacitance Cp is present between the source interjunction of the MOS transistor 32 with the MOS transistors 33 and the ground.

In the boosting circuit thus arranged, the output voltage $V_{CCX}$ is independent of the frequency f and is given as

$$V_{ccx} = V_{cc} - 2V_T + \frac{C}{C+Cp} V_{cc} \qquad (1)$$

If the capacitance of the capacitor C is much larger than that of the stray capacitance Cp, equation (1) is rewritten as

$$V_{ccx} = 2(V_{cc} - V_T) \qquad (2)$$

where $V_T$ designates the threshold voltage $V_T$ of the MOS transistors 32 and 33.

By designing the circuit of Fig. 3 in a manner such that equation (2) holds, the output voltage $V_{ccx}$ obtained is 4 V when the power source voltage $V_{cc}$=2.5 V and the threshold voltage $V_T$=0.5 V. When $V_{cc}$=3 V and $V_T$=0.5 V, the output voltage $V_{ccx}$ is 5 V.

Fig. 4 shows a practical arrangement of the switch circuit 12.

An N-channel depletion type MOS transistor 41 and an N-channel enhancement type MOS transistor 42 make up a first inverter 43. An N-channel depletion type MOS transistor 44 and an N-channel enhancement type MOS transistor 45 form a second inverter 46. The drain of the MOS transistor 41 is connected to the power source voltage $V_{CC}$ and its source is connected to the drain of the MOS transistor 42. The gate of the MOS transistor 41 is connected to its source. The power source voltage $V_{CC}$ is applied to the gate of the MOS transistor 42. The source of the MOS transistor 42 is connected to the reference voltage $V_{SS}$ (0 V). The drain of the MOS transistor 44 is connected to the power source voltage $V_{CC}$ and its source is connected to the drain of the MOS transistor 45. The gate of the MOS transistor 44 is coupled with the source thereof. The source of the MOS transistor 45 is connected to the reference voltage $V_{SS}$. The gate of the MOS transistor 45 is connected to an output node N43 of the inverter 43, i.e. the interjunction between the MOS transistors 41 and 42. The source of a P-channel enhancement type MOS transistor 47 is connected to the power source voltage $V_{CC}$ and its drain is connected to the drain of a P-channel enhancement type MOS transistor 48. The source of the MOS transistor 48 is applied with the output voltage $V_{CCX}$ from the boosting circuit 11. The junction between the MOS transistors 47 and 48 forms an output node N49 of the switch circuit 12, through which the power source voltage $V_{CC}$ or $V_{CCX}$ selected by the switch circuit 12 is taken out as the power source voltage $V_{CCS}$. The gate of the MOS transistor 47 is connected to the output node N43 of the first inverter 43. The gate of the MOS transistor 48 is connected to the output node N46 of the second inverter 46, i.e., the junction between the MOS transistors 44 and 45.

The operation of the switch circuit 12 with such an arrangement will now be described. Assume now that the threshold voltages $V_T$ of the MOS transistor 42 is approximately 3 V, and the threshold voltages $V_T$ of the MOS transistors 45, 47 and 48 is approximately 0.5 V, -0.5 V and -0.5 V, respectively.

In an operation mode, the applied power source voltage $V_{cc}$ is 5 V. In this case, the MOS transistor 42 is turned on and the potential at the node N43 is 0 V. The MOS transistor 45 is turned off and the node N46 has a potential of 5 V. Further, the MOS transistor 47 is turned on and the MOS transistor is turned off. As a result, the switch circuit 12 produces the power source voltage $V_{CC}$ of approximately 5 V as the power source voltage $V_{CCS}$ through the MOS transistor 47. In the data hold mode, when the power source voltage $V_{cc}$ is approximately 2.5 V, the node N43 is at 2.5 V since the MOS transistor 42 is off. Then, the MOS transistor 45 is on and the node N46 is at 0 V. Further, the MOS transistor 47 is off and the MOS transistor 48 is on. Consequently, the switch circuit 12 produces the power source voltage $V_{CCS}$ via the MOS transistor 48. In this case, the power source voltage $V_{CCS}$ is the output voltage $V_{CCX}$ of, for example, 4 V, from the boosting circuit 11. The voltages at the nodes N43, N46 and N49 against $V_{cc}$ are indicated below.

TABLE 1

| $V_{cc}$ | N43 | N46 | N49 ($V_{ccs}$) |
|---|---|---|---|
| 5 V | 0 V | 5 V | 5 V |
| 2.5V | 2.5 V | 0 V | 4 V |

Turning now to Fig. 5, there is shown an example of the power source circuit used in the boosting circuit shown in Fig. 3. In this circuit arrangement, the ring oscillator 31 is coupled with the output voltage $V_{ccp}$ of a power source circuit 50, while in Fig. 3 arrangement, the ring oscillator 31 is directly coupled with the power source $V_{cc}$. The circuit arrangement of Fig. 5 shows the boosting circuit 11 to operate only in the batter back-up mode. In Fig. 5, MOS transistors 51 and 54 are of N-channel and depletion type, and MOS transistors 52, 55 and 58 are N-channel and enhancement type. A MOS transitor 57 is of P-channel and enhancement type. The MOS transistors 51 and 52 make up an E/D (enhancement/depletion) inverter 53. The MOS transistors 54 and 55 likewise make up another E/D inverter 56. The MOS transistors 57 and 58 form a CMOS (complementary metal oxide semiconductor) inverter 59. The MOS transitor 51 is connected at the drain to the power source voltage $V_{cc}$ and at the source to the drain of the MOS transistor 52. The gate of the MOS transistor 51 is connected to its source. The MOS transistor 52 is connected at the source to the reference voltage $V_{ss}$ (0 V), and at the gate to the power source voltage $V_{cc}$. The junction between the MOS transistors 51 and 52 provides an output node N53 of the inverter 53. The MOS transistor 54 is connected at the drain to the power source voltage $V_{cc}$ and at the source to the drain of the MOS transistor 55. The gate of the MOS transistor 54 is connected to its source. The source of the MOS transistor 55 is connected to the reference voltage $V_{ss}$ and the gate thereof is connected to the output node N53 of the inverter 53. The junction between the MOS transistors 54 and 55 provides an output node N56 of the inverter 56. The MOS transistor 57 is connected at the source to the power source voltage $V_{cc}$ and at the drain to the drain of the MOS transistor 58. The source of the MOS transistor 58 is coupled with the reference voltage $V_{ss}$. The gates of the MOS transistors 57 and 58 are both connected to the output node N56 of the MOS transistor 56. The junction between the MOS transistors 57 and 58 provides an output node N59 of the inverter 59, and also provides an output terminal of the power source circuit 50.

The operation of the power source circuit 50 will now be described. It is assumed that the threshold voltage $V_T$ of the MOS transistor 52 is approximately 3 V, and that the threshold voltage $V_T$ of the MOS transistors 55 and 58 is approximately 0.5 V, and that of the MOS transistor 57 is −0.5 V.

If the supplied power source voltage $V_{cc}$ is 5 V, the MOS transistor 52 is turned on and a potential at the node N53 is 0 V. Then, the MOS transistor 55 is burned off and a potential at the node N56 is 5 V. Accordingly, the MOS transistor 57 is turned off and the MOS transistor 58 is turned on. As a result, at the output node N59 the output power source voltage $V_{ccp}$ becomes the reference voltage $V_{ss}$, and this reference voltage $V_{ss}$ is applied to the ring oscillator 31 as the power source voltage to the boosting circuit 11. Specifically, when the power source voltage $V_{cc}$ is 5 V, 0 V is applied to the ring oscillator 31. The ring oscillator 31, and hence, the boosting circuit 11 will not operate.

Then, the power supply system of the semiconductor memory device is switched to the battery back-up system. In this mode, the MOS transistor 52 is turned off and the node 53 has a potential of 2.5 V. The result is that the MOS transistor 55 is on and the node N56 is 0 V. In turn, the MOS transistor 57 is turned on and the MOS transistor 58 is turned off. In this condition, the output power source voltage $V_{ccp}$ is the power source voltage $V_{cc}$ which is then applied to the ring oscillator 31. Thereby, the boosting circuit 11 is driven to operate. The output voltage $V_{ccx}$, for example, 4 V, of the switch circuit 12 is applied to the memory cell. The voltages, which are applied to the key points when the power source circuit 50 is operating as mentioned above, are listed below.

TABLE 2

| $V_{cc}$ | N53 | N56 | N59 ($V_{ccp}$) |
|---|---|---|---|
| 5 V | 0 V | 5 V | 0 V |
| 2.5 V | 2.5 V | 0 V | 2.5 V |

When the power source circuit as mentioned above is used for the ring oscillator 31, the voltage applied to the ring oscillator 31 is 0 V when the power source voltage $V_{cc}$ is 5 V. The result is that the ring oscillator 31, and hence the boosting circuit 11, does not operate. Thus, power saving is achieved.

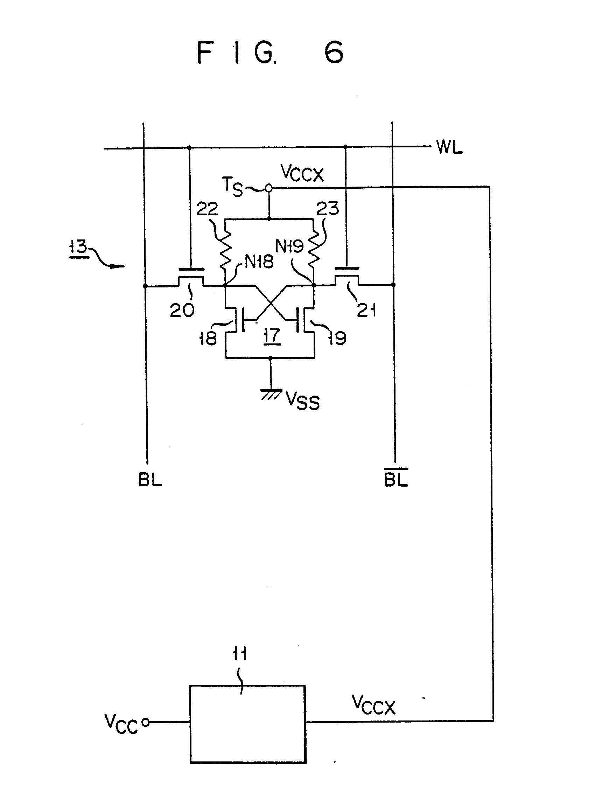

Fig. 6 shows another embodiment of a semiconductor memory device according to this invention. In this embodiment, the switch circuit 12, which is used in the embodiment of Fig. 3, is omitted. Further, the output voltage $V_{ccx}$ of the boosting circuit 11 is directly connected to the power source terminal Ts of the memory cell 13. The remaining portion is the same as that of the Fig. 3 embodiment. No further explanation will be given and like reference numerals will be applied to like or equivalent portions.

In this embodiment, the output voltage $V_{ccx}$ boosted by the boosting circuit 11 is always applied to the memory cell 13. When the power source voltage $V_{cc}$ is 5 V in an operation mode, the output voltage $V_{ccx}$, for example, 9 V, which is obtained by the boosting circuit 11 $(V_{ccx}=2(V_{cc}-V_T)=9\ V)$, is applied to the semiconductor memory cell 13. When the semiconductor memory device is battery-driven with the $V_{cc}$ of 2.5 V in the wait mode, the $V_{ccx}$ of about 4 V boosted by the boosting circuit 11 is applied to the memory cell 13. Therefore, this embodiment can prevent the soft error in the same way as the Fig. 3 embodiment does. In the Fig. 6 embodiment, the output voltage $V_{ccx}$ of the boosting circuit 11 is applied as the power source voltage to the semiconductor memory cell 13. Accordingly, this embodiment does not need the power source circuit 50 as shown in Fig. 5 which supplies the 0 V output voltage in an operation mode.

It should be understood that this invention is not limited to the above-mentioned embodiments. For example, the boosting circuit and the switch circuit may be replaced with any other circuits if these have the same functions as the former.

As seen from the foregoing description, the boosting circuit used in this invention sufficiently boosts the low voltage source when the semiconductor memory device is backed up by the battery in a wait mode. The boosted power source is applied to the memory cell in the wait mode. Therefore, the data storage in this mode is highly reliable. Further, the semiconductor memory device of the invention is improved in its resistance to alpha particles and is thus substantially free from the soft error problem.

## Claims

1. A static type semiconductor memory device comprising:
means (11) for boosting a power source voltage $(V_{cc})$; and
a static memory cell (13) for receiving the boosted output voltage $(V_{ccx})$ from said boosting means (11) as a power source voltage $(V_{ccs})$,
switch means (12) provided between said boosting means (11) and said memory cell (13) and coupled with the power source voltage $(V_{cc})$ and the boosted output voltage $(V_{ccx})$, said switch means (12) selecting the boosted output voltage $(V_{ccx})$ in a wait mode while selecting the power source voltage $(V_{cc})$ in an operation mode, the selected voltage being applied as the power source voltage $(V_{ccs})$ to said memory cell (13).

2. A static type semiconductor memory device according to claim 1, characterized by further comprising power source means (50) supplying an output power source voltage $(V_{ccP})$ to said boosting means (11), and wherein said power source means (50) stops said supply and renders said boosting means (11) inoperative when said memory cell (13) is in said operation mode, while allowing said supply thereby operating said boosting means (11) in said wait mode.

3. A static type semiconductor memory device according to claim 1, characterized in that said memory cell (13) includes first and second MOS transistors (18, 19) in which the drain and gate of one of said MOS transistors are respectively connected to the gate and drain of the other MOS transistor, a first load element (22) which is connected at one end to the drain of said first MOS transistor (18), and at the other end to the power source voltage $(V_{ccs})$, and a second load element (23) which is connected at one end to the drain of said second MOS transistor (19) and at the other end to the power source voltage $(V_{ccs})$.

4. A static type semiconductor memory device according to claim 3, characterized in that said first and second load element (22, 23) are resistors.

## Patentansprüche

1. Halbleiterspeicheranordnung vom statischen Typ mit:
einer Einrichtung (11) (Booster) zum Anheben einer Spannungsquellen-Spannung $(V_{cc})$,
einer statischen Speicherzelle (13) zum Empfangen der angehobenen Ausgangsspannung $(V_{ccx})$ von der Anhebungseinrichtung (11) als eine Spannungsquellen-Spannung $(V_{ccs})$,
einer zwischen der Anhebungseinrichtung (11) und der Speicherzelle (13) vorgesehenen und mit der Spannungsquellen-Spannung $(V_{cc})$ und der angehobenen Ausgangsspannung $(V_{ccx})$ gekoppelten Schaltereinrichtung (12), die die angehobene Ausgangsspannung $(V_{ccx})$ in einem Wartemodus auswählt, während sie ·ue Spannungsquellen-Spannung $(V_{cc})$ in einem Betriebsmodus auswählt, wobei die ausgewählte Spannung als die Spannungsquellen-Spannung $(V_{ccs})$ an der Speicherzelle (13) liegt.

2. Halbleiterspeicheranordnung vom Statischen Typ nach Anspruch 1, gekennzeichnet durch eine Spannungsquelleneinrichtung (50), die eine Ausgangsspannungsquellen-Spannung $(V_{ccP})$ an die Anhebungseinrichtung (11) anlegt, wobei die Spannungsquelleneinrichtung (50) die Einspeisung unterbricht und die Anhebungseinrichtung (11) außer Betrieb setzt, wenn die Speicherzelle (13) im Betriebsmodus ist, während side die Einspeisung zum Betreiben der Anhebungseinrichtung (11) im Wartemodus erlaubt.

3. Halbleiterspeicheranordnung nach Anspruch 1, dadurch gekennzeichnet, daß die Speicherzelle (13) erste und zweite MOS-Transistoren (18, 19), wobei Drain und Gate von einem der MOS-Transistoren mit Gate bzw. Drain vom anderen MOS-Transistor verbunden sind, ein erstes Lastelement (22), das an einem Ende mit Drain des ersten MOS-Transistors (18) und am anderen Ende mit der Spannungsquellen-Spannung $(V_{ccs})$ verbunden ist, und ein zweites Lastelement (23), das an einem Ende mit Drain des zweite MOS-Transistors (19) und am anderen Ende mit der Spannungsquellen-Spannung $(V_{ccs})$ verbunden ist, aufweist.

4. Halbleiterspeicheranordnung vom statischen Typ nach Anspruch 3, dadurch gekennzeichnet, daß das erste und das zweite Lastelement (22, 23) Widerstände sind.

## Revendications

1. Dispositif à mémoire à semi-conducteur du type statique comportant:

un dispositif (11) destiné à élever une tension d'alimentation ($V_{cc}$); et

une cellule de mémoire statique (13) destinée à recevoir la tension de sortie élevée ($V_{ccx}$) provenant dudit dispositif élévateur (11) comme une tension d'alimentation ($V_{ccs}$),

un dispositif de commutation (12) disposé entre ledit dispositif élévateur (11) et ladite cellule de mémoire (13) et couplé avec la tension d'alimentation ($V_{cc}$) et la tension de sortie élevée ($V_{ccx}$), ledit dispositif de commutation (12) sélectionnant la tension de sortie élevée ($V_{ccx}$) dans un mode d'attente tout en sélectionnant la tension d'alimentation ($V_{cc}$) dans un mode de fonctionnement, la tension sélectionnée étant appliquée comme tension d'alimentation ($V_{ccs}$) à ladite cellule de mémoire (13).

2. Dispositif à mémoire à semi-conducteur du type statique selon la revendication 1, caractérisé en ce qu'il comporte en outre un dispositif d'alimentation (50) fournissant une tension d'ali- mentation de sortie ($V_{ccp}$) audit dispositif élévateur (11) et dans lequel ledit dispositif d'alimentation (50) interrompt ladite fourniture et rend inopérant ledit dispositif élévateur (11) quand ladize cellule de mémoire (13) se trouve dans ledit mode de fonctionnement tout en permettant ladite fourniture, alimentant ainsi ledit dispositif élévateur (11) dans ledit mode d'attente.

3. Dispositif à mémoire à semi-conducteur du type statique selon la revendication 1, caractérisé en ce que ladite cellule de mémoire (13) comporte un premier et un second transistors MOS (18, 19) dans lesquels le drain et la grille de l'un desdits transistors MOS sont connectés respectivement à la grille et au drain de l'autre transistor MOS, un premier élément de charge (22) qui est connecté par une extrémité au drain dudit premier transistor MOS (18) et par l'autre extrémité à la tension d'alimentation ($V_{ccs}$) et un second élément de charge (23) qui est connecté par une extrémité au drain dudit second transistor MOS (19) et par l'autre extrémité à la tension d'alimentation ($V_{ccs}$).

4. Dispositif à mémoire à semi-conducteur du type statique selon la revendication 3, caractérisé en ce que ledit premier et ledit second éléments de charge (22, 23) sont des résistances.

# F I G. 1

# F I G. 3

# F I G. 2

# F I G. 4

# F I G. 5

# F I G. 6